Europäisches Patentamt

European Patent Office

Office européen des brevets

(11) Publication number: **0 684 483 A2**

# EUROPEAN PATENT APPLICATION

(21) Application number: **95201178.1**

(51) Int. Cl.6: **G01R 31/34**

(22) Date of filing: **08.05.95**

(30) Priority: **23.05.94 IT MI941040**

(43) Date of publication of application:
**29.11.95 Bulletin 95/48**

(84) Designated Contracting States:
**AT BE CH DE DK ES FR GB GR IE IT LI LU MC NL PT SE**

(71) Applicant: **ANSALDO ENERGIA S.P.A.**
**Via Nicola Lorenzi 8**
**I-16152 Genova (IT)**

(72) Inventor: **Mori, Luigi**
**Via Donghi, 23/15**
**I-16132 Genova (IT)**
Inventor: **Santolo, Vincenzo**
**Corso L.A. Martinetti, 127/7**
**I-16149 Genova (IT)**

(74) Representative: **Falcetti, Carlo et al**
**c/o JACOBACCI & PERANI S.p.A.**
**Via Visconti di Modrone, 7**
**I-20122 Milano (IT)**

(54) **An apparatus and troubleshooting method for monitoring the operability of rotating electric generators such as turboalternators.**

(57) An apparatus and troubleshooting method for monitoring the operability of turboalternators without removing their rotors, comprising a pair of rings (1,3) with an outward toothed rim attached to the rotor (2) end and being provided each with a powered unit (4,5) controlled to assume a predetermined angular position on the toothed rim, a moving carriage (11) inserted into the air gap between the stator (15) and the rotor (2) and driven by a cable (9) stretched between the two units (4,5), the carriage (11) supporting a light source (35), an inspection TV camera (33), a sensor of shorts between laminations of the stator core, striking means (36) coupled to an accelerometer (37) for controllably striking stator slot wedges and detecting the striking deceleration, means of acoustically detecting the impact noise, and remote control means (8) for the powered units (4,5) and the carriage (11) and of receiving, storing, and processing the signals generated by said sensors.

FIG.1

The present invention relates to an apparatus and associated troubleshooting method, which enables rotating electric generators, specifically turboalternators, to be serviced without removing their rotors.

With electric power machines, such as turboalternators, it is necessary that the utilization of the machines be optimized by minimizing the downtime required for their maintenance and inspection.

With these machines, maintenance and inspection should have a preventive character, so as to correct faults on their inception, before they become a cause of irreparable damage.

Among the most dangerous problems that may occur during the operation of a power alternator, such as a turboalternator, are shortings between stator core laminations and loosened wedges in the stator slots.

To check for shorts and for sufficient pressure of the wedges on the conductor rods within the slots, it is necessary to periodically stop the generator and remove the rotor from the stator, an operation that involves almost complete dismantling of the electric machine.

With the rotor removed, an operator can reach the stator interior to check for shorts between stator core laminations and manually check the wedge fit, as well as visually inspect the stator for overheating marks, presence of foreign matter, dislodged components such as the ventilation channel spacers, loosened or broken laminations, dislodged wedges, machine cleanliness, oil contamination, etc..

If any faults are found, the necessary corrective measures must be taken, which usually involve the procurement of spare parts and the availability of repair equipment. Finally, the machine is to be reassembled and test run, before normal operation can be resumed.

This servicing procedure is, therefore, cumbersome and time-consuming, even where no serious faults are found, and its completion may take some 40-42 days if there are no parts that require re-conditioning or replacement, and a much longer time if there are any.

In order to speed up the troubleshooting procedure and reduce servicing time, certain apparatus have been proposed and made which enable the electric machine to be checked, within limits, without removing the rotor.

Such limitations are overcome by the apparatus and associated troubleshooting method according to the present invention, whereby both shorted stator core laminations and surface appearance at the gap between the rotor and stator and the state of the wedges can be ascertained by visual inspection and periodical testing of their fit.

Furthermore, use is made for such tests of response signals from the combination of an accelerometer and a microphone which reproduce, and enable to be processed in a systematic homogeneous repeated fashion, signals of the type which is normally detected and interpreted somewhat subjectively during manual checking operations.

According to another aspect of the present invention, the mechanical fit tests of the wedges are compensated for and unaffected by gravitational effects and assembly tolerances.

These results are obtained by an apparatus which comprises, in accordance with the invention, a pair of toothed rings, being mounted on the end of a rotor of an electric machine and provided each with a powered unit rotatively controlled on the rings to take predetermined angular positions on one of said rings.

Stretched between the two powered units is an axially moving cable drive which causes a carriage attached to the cable to take a number of predetermined positions along the axial length of the stator.

The carriage, being provided with guide rollers which co-operate with stator slots and inserted between the stator and the rotor, will assume, by the combined actions of the powered units and the cable drive, a plurality of axial and radial positions within the machine air gap, and scan the whole annular surface of the air gap at a predetermined spacing from the stator surface.

Illuminating and optical detection means mounted on the carriage enable the whole air gap to be inspected visually.

An inductance means mounted on the carriage allows any stray currents to be detected.

A striker means, coupled to an accelerometer and an acoustical detector means, also mounted on the carriage, enables the fit of the various wedges in the stator slots to be checked as the air gap is being scanned by the carriage.

Also provided is a means of controlling the amount of energy delivered to the striker means according to the angular positions of the powered units and the carriage, thereby to compensate for gravity effects on the striker means.

The features and advantages of the invention will be more clearly apparent from the following description of a preferred embodiment and the accompanying drawings, in which:

Figure 1 is a perspective view showing schematically the apparatus of this invention and its essential components;

Figure 2 is a cross-sectional view of the moving carriage of the apparatus in Figure 1, taken on a transverse plane to the running direction;

Figure 3 is a side view showing schematically the monitoring devices mounted on the carriage in Figure 2;

Figure 4 is a mechanical schematic illustrating a preferred embodiment of the striker device for the stator slot wedges as mounted on the carriage in Figure 2;

Figure 5 shows schematically the striker device of Figure 4 and an associated distance measuring device, as viewed from a transverse direction to the carriage running direction.

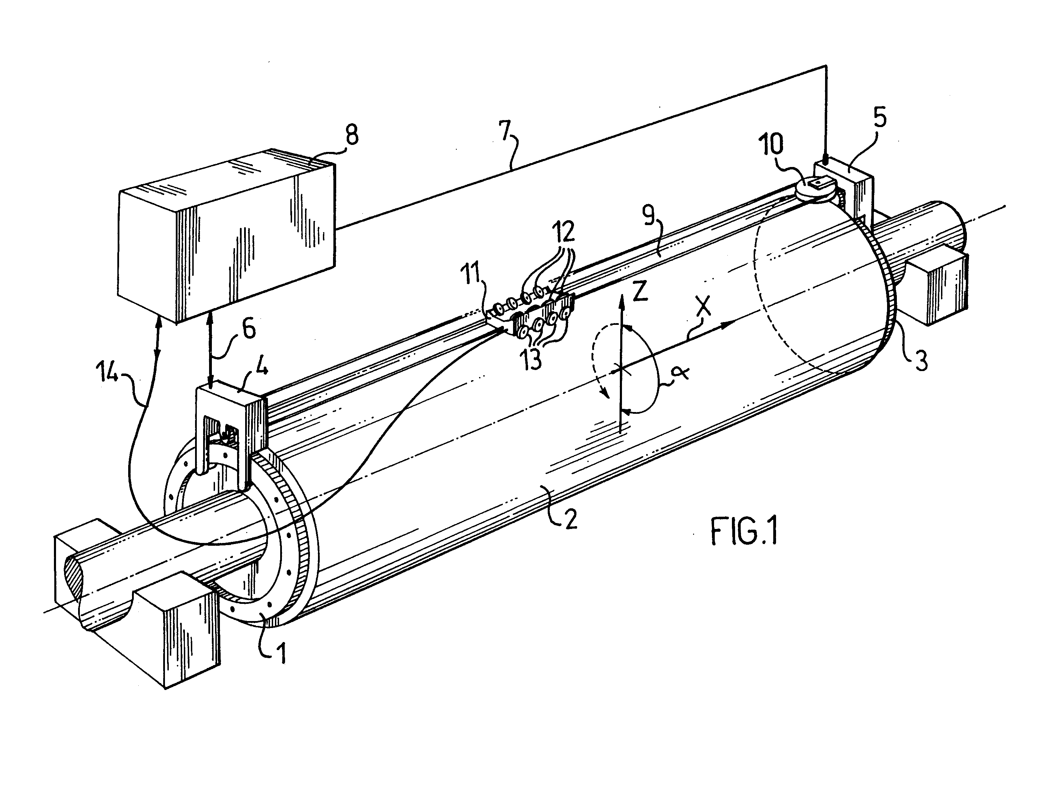

With reference to Figure 1, the apparatus of this invention comprises a first ring 1, with an outward toothed rim, which is secured on the end of an electric generator rotor 2 having a generally horizontal axis.

Secured on the opposite end of the rotor 2 is a second ring 3, also with an outward toothed rim.

To complete this operation, it is generally sufficient to just disassemble the rotor ring chamber, the upper head shields of the machine, and possibly the upper portion of the rotor bearings, the rotor being then supported on the lower bearings.

In this way, the rotor heads are made accessible to which the rings can be attached by means of clamping flanges or bolts threaded into suitable sockets in the rotor heads.

Access is also gained to the machine air gap whose breadth is, for a power generator, on the order of 40 mm.

The rings 1 and 3 support each a powered unit 4 and 5, respectively.

The powered units 4 and 5 are provided with a pinion gear in mesh engagement with the toothed rims of the rings and with guide rollers, and can rotate on the rings under commands which are received through communication channels 6, 7 from a supervisory system 8.

Through the channels 6, 7, the powered carriages, which are provided with position recognizing members such as encoders, send position signals to the supervisory system which allow recognition of the angular positions of the units on the rings, their phasing (i.e., their location in the same angular position along the same rotor generatrix line), and their position feedback control.

To ensure correct phasing, optical collimation systems are also suitably provided.

Stretched between the two powered units 4, 5 is an inextensible steel cable 9 which may be reeled off one unit and taken up on the opposite unit, and vice versa.

Preferably and alternatively, as shown in Figure 1, the cable 9 is stretched between one of the units, such as 4, and a deflector pulley 10 attached to the other unit 5, so that it can be unwound from and wound back onto the same unit 4, the necessary tension on the cable being provided by an elastic attachment of the deflector pulley 10 to the unit 5.

Attached to the cable 9 is a flattened carriage having such dimensions as to fit slidably in the air gap between the rotor and the stator of the electric generator.

The carriage is provided with a first set 12 of guide rollers arranged to roll over the stator surface, and a second set 13 of guide rollers arranged to roll over the rotor surface.

It will be understood that by suitable operation of the powered units 4, 5 and the cable drive 9 under control by the supervisory system 8, the carriage 11 can be shifted to any desired position on the whole cylindrical surface of the rotor 2 and corresponding rotor surface, by traversing movement along the rotor axis X and angular rotations of a predetermined amplitude about the rotor axis X and relative to a preset reference of the powered units 4, 5.

Mounted on the carriage 11 are a plurality of sensors and detectors which are communicated to the supervisory unit 18 by a plurality of leads making up a communication channel 14.

The stator enclosing the rotor 2 has been omitted from Figure 1 to expose the rings 1, 3 and carriage 11.

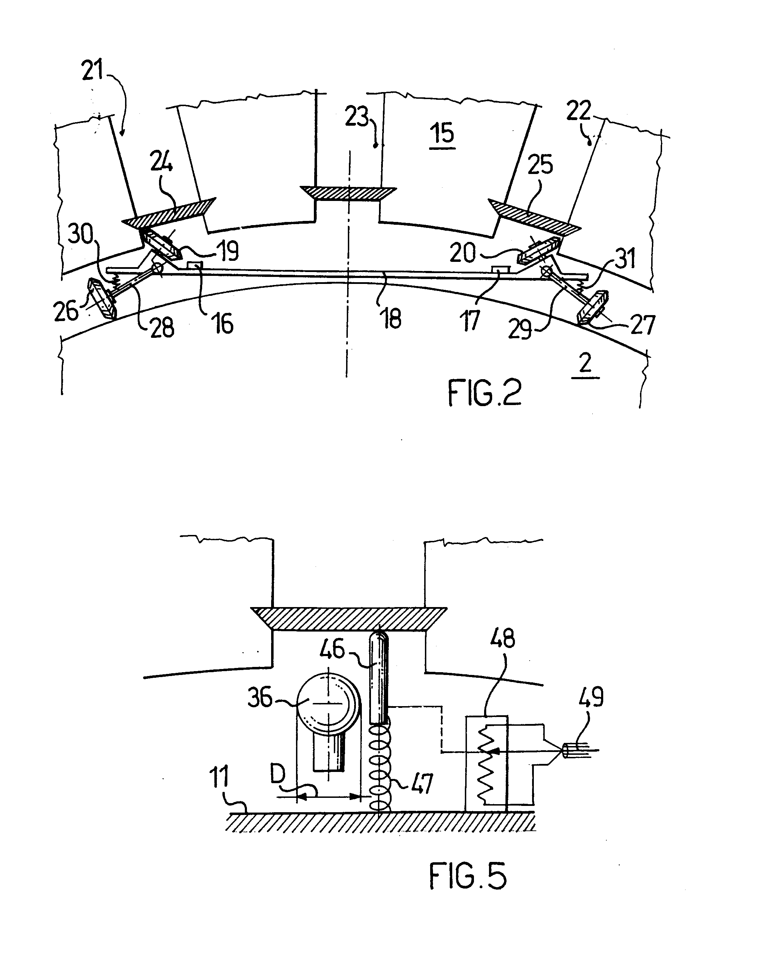

Figure 2 shows in cross-section, taken perpendicularly to the rotor axis X, the mechanical structure of the carriage 11 in its relation to a portion of the stator 15 and the rotor 2.

The frame of the carriage 11 is formed of two parallel stringers 16, 7 connected together by a plurality of crosspieces such as 18.

Freely pivoted on each end of the crosspieces such as 18 is a guide roller such as 19, 20.

The pivot axis of the rollers 19, 20, lying perpendicular to the traversing direction of the carriage, is given a suitable oblique setting on the stator surface with which the rollers 19 and 20 come in coontact and allows each of the guide rollers 19 and 20 to be started in the groove formed by two stator slots 21, 22 contiguous to an intermediate slot 23, acting with their rolling profiles against the closure wedges 24, 25 of the slots 21, 22.

The spacing between guide rollers 19, 20 would obviously be determined by the distance separating the stator slots such as 21, 22, and is illustratively on the order of 180 mm.

Illustratively, a stator slot has a width in the 27 to 30 mm range and is separated from its contiguous slots by sheet metal teeth having a width on the order of 45 mm.

The surface of the wedges 24, 25 facing the air gap is set from the ends of the stator teeth to a depth of about 15 mm.

Thus, the set of paired guide rollers such as 19, 20 allow the carriage frame to be positioned accurately along a pair of stator slots 21, 22, with the frame being suitably centered to and spaced from an intermediate stator slot 23, even when the carriage locates at stator surfaces which lie non horizontally.

In this circumstance, the tension on the cable 9 would be inadequate to ensure correct positioning of the carriage along the slots due to the carriage and cable own weights.

The pressure contact of the guide rollers 19 and 20 with the stator slots is ensured by a second set of guide rollers, such as 26, 27, which are mounted on swivel mounts 28, 29 pivoted on the frame and urged against the surface of the rotor 2 by such resilient elements as compression springs 30, 31 or some equivalent arrangements.

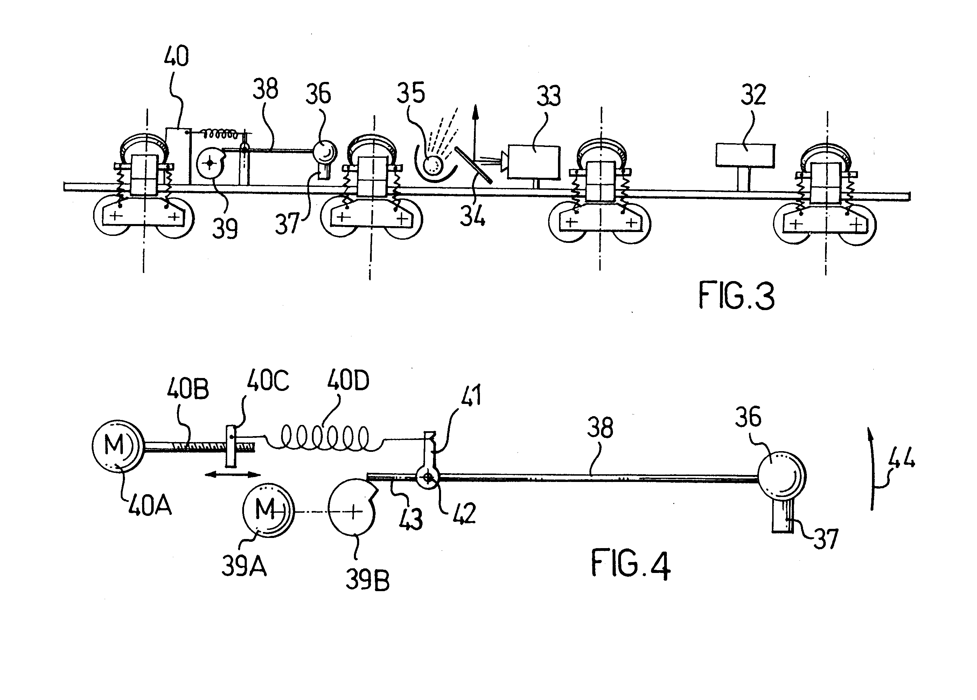

Secured on the carriage frame are suitable sensors and instruments as shown in Figure 3, by a longitudinal schematic view of the carriage 11.

An inductive element 32, known as chattock sensor in a detection system known per se, by magnetic coupling to a set of stator laminations (as suitably magnetized by currents being applied to the stator winding), enables the presence to be detected of any shorts between laminations which would be the cause of larger local stray currents and corresponding magnetic induction drops across the air gap.

A miniaturized television camera 33, with a charge coupled device (CCD) sensor, enables imaging of two portions of the stator and the rotor under examination as reflected through suitable mirrors 34.

The illumination of the surfaces under examination is ensured by appropriate controlled light sources (lamps or optical fibers) indicated schematically by the lamp 35.

A striker consisting of a small metal ball 36 coupled to an accelerometer 37 and mounted on the free end of an actuating arm 38 provides a striking means for controllably striking stator slot wedges.

The actuating arm 38 is pivoted on the frame and co-operates with a setting cam system 39 and an adjustable elastic load system 40, more clearly shown in Figure 4.

The striking means is periodically and repetitively operated to strike, even more than once, each of the various stator slot wedges, with a predetermined amount of impression energy.

The deceleration to which the striker is subjected upon impact and the noise generated by the impact are a function of the rigidity of the fit between wedge, stator toothing, and conductor rod.

The accelerometer 37 and a directional microphone 40 allow the deceleration and impact-generated noise to be respectively detected.

Clearly, all the signals detected by the above sensors are sent to the supervisory system 8, which can be programmed for sampling, storing and processing them to provide the operator with suitable indications and displays by sending the necessary control signals to the actuator devices of the apparatus.

The method of checking the wedge fit by striking, and the striking instruments provided for the purpose require to be described in greater detail.

The striker deceleration brought about by the impact against the wedge and the noise generated by the impact, not only as to timbre or fundamental and harmonic acoustic frequencies but also as to the amount of acoustic energy produced, provide a useful indication of the hold state of the wedge, measurable in a more accurate and precise manner than with methods of manual stimulation and subjective evaluation of the symptoms, but to be effective, require that the stimulation be repetitive and unaffected by the working conditions.

In practice, the striker must be driven, at the time of impacting, with a predetermined kinetic energy and the impact, being of a ballistic kind, should be unaffected by varying conditions in the striker bond.

To achieve this, the striking means employed have the construction shown in Figure 4.

The striker 36, in the form of a small ball, is mounted, integrally with an accelerometer 37, on the free end of the actuating arm 38 pivoted about a pin 42 on the carriage.

The mass and momentum of the actuating arm are negligible compared to the mass and momentum of the ball and the accelerometer.

The actuating arm 38 extends into a setting arm 43 and a loading arm 41 essentially perpendicular to the actuating arm.

The adjustable elastic load system of the striker comprises a motor 40A driving a screw 20B on which a nut 40C is threaded to apply tension to a spring or resilient element 40D, having its ends attached to the nut 40C and the end of the loading arm 41, respectively.

The spring tension develops a controlled and adjustable (by shifting the nut 40C) torque directed to swing the striker in the direction of an arrow 44.

The setting system comprises basically a motor 39A which periodically rotates a cam 39B whose profile acts on the end of the setting arm 43.

Calling F the force exerted by the spring 40, L41 the length of the arm 41, L38 the length of the arm 38, and M the mass of the ball 36 and the accelerometer, the acceleration imparted to the striker is given with sufficient accuracy by

$$A = F.L41/M.L38,$$

and if the change in the spring length due to the rotation of the arm 41 and being negligible compared to the load elongation imparted by the load system (as is achieved in practice by design) it can be regarded to be constant through the time period when the striker is being thrown toward the wedge.

Absent any other forces acting on the striker, its movement and kinetic energy upon striking are strictly determined by known basic dynamic laws and only dependent on F and the stroke length S of the striker.

It should not be overlooked, however, that the striker is also acted upon by a gravity force FG which may add to or detract from the acceleration imparted by the force F in varying degrees, according to the carriage position relative to the stator.

To accommodate this effect, the force F exerted by the spring 40D is adjusted to suit the angular position of the powered units, and hence the carriage, considering that by calling the angular position with respect to the lowest position taken by the carriage, the gravity force acting on the striker is given by the relation

$$FG = M.G.cos\alpha.$$

This compensation can be provided for all the measurements performed on wedges in one slot.

Although feasible, it would not be convenient to have the tension F of the spring adjusted according to the distance of the striker at rest from the wedge at each striking operation.

This is defined with sufficient accuracy around a nominal value by the correct positioning of the carriage relative to the wedges, as imposed by the two sets of guide rollers and the correct positioning of the wedges relative to the respective stator mortises.

Excess variations from the nominal distance may only occur due to backlash and dislodging of the wedge under examination: the likelihood of all the wedges which simultaneously interact with the guide rollers that define the carriage position being dislodged is extremely small.

These variations can be conveniently taken into account by checking, as shown in Figure 5, the actual distance of the carriage, and hence the striker, from the point of impact on the wedge.

Suitably provided beside the striker 36 transversely to the direction of movement of the carriage, is a sliding shoe 46 which is urged by a resilient means 47 toward the surface of the wedge under examination, close to the point of impact of the striker 36.

The shoe 46 is coupled mechanically to the sliding contact of a potentiometer 48 which supplies a signal related to the wedge distance.

Illustratively, the striker 36 may have a diameter of 10 mm and the shoe 46 may have a transverse thickness of 3 mm, so that the distance of the wedge can be measured in the immediate vicinity of the impact point (about 7 mm away) with great accuracy.

The potentiometer 48 reading, as sent to the supervisory system over leads 49, can be used to validate the operation of the striker if the measured distance falls within a predetermined range, or to supply a strike-inhibit warning signal if the measured distance reveals absence or dislodgement of a wedge.

The potentiometer 48 reading can also be used to correct, according to the distance variation from the nominal value, the readings from the other sensors, in particular for equidistantly normalizing the measured striking decelerations.

The apparatus described hereinabove permits a systematic troubleshooting method to be implemented for monitoring the operability of an electric generator without removing the rotor, which enables advancement of the identification of the work to be performed on the stator to the initial stages of the machine overhaul schedule, and in the extreme the removal of the rotor to be avoided where no work need to be carried out which requires such removal.

The apparatus may be conveniently implemented as a movable monitoring system, easily transported since it is basically comprised of a control panel housing the supervisory system, connection harness, a pair of rings with toothed rims, a carriage driving cable, and a carriage of reduced size.

Accordingly, the apparatus can be easily transported at times to different plants where an electric generator requires overhauling.

After mounting the pair of rings with toothed rims on the rotor, tensioning the cable drive between the powered units of the rings, inserting the measuring carriage between the rotor and the stator, and establishing the electric connections to the supervisory system, the measuring operations can be started in a scheduled manner.

Each measuring operation includes the steps of:

detecting and possibly recording an image of the stator and the rotor, followed by visual inspection of the same;

locating any shorts between stator laminations in the inspected area;

striking, with a predetermined amount of striking energy, a stator slot wedge, and measuring and recording the impact deceleration and the acoustic signal generated by the impact; the acoustic signal, which may be listened into earphones, is then processed by the supervisory system, and in particular by double integration, an indication of the sound energy produced by the striking can be obtained; additional processing may then include spectral analysis of the sound;

measuring and storing the distance between the wedge and the carriage as sampled upon striking.

All the above information, as preferably converted to and processed in digital form, may be displayed to the operator in the form of synoptic tables on a TV screen and/or in the form of printouts, and be supplemented with warning indications of problems found.

The foregoing description only covers a preferred embodiment of the apparatus and troubleshooting method, and it should be understood that many changes may be made thereunto without departing from the spirit of the invention.

## Claims

1. A troubleshooting apparatus for monitoring the operability of rotating electric generators, of the type wherein a moving carriage (11) provided with sensors is inserted slidably between the stator (15) and the rotor (2) of the rotary machine, characterized in that it comprises:

a pair of toothed rings (1,3) mounted on the ends of a rotor (2), each ring being provided with a powered unit (4,5) which is controlled to assume a predetermined position on its associated ring,

a carriage (11) provided with a first set of guide rollers (13) mounted on elastic supports for resting said carriage (11) on said rotor (2), and with a second set of guide rollers (12) for resting and guiding said carriage along a stator slot defined by the position of said powered units,

a cable drive (9) stretched between said powered units (4,5) and hooked to said carriage (11) for shifting said carriage to predetermined positions along said stator slot (15), said carriage having the following components mounted thereon:

illuminating (35) and optical detection (33,34) means,

stray current detection means (32),

striking means (36,38,39) coupled to an accelerometer (37) for controllably striking stator slot wedges and for detecting the striking deceleration,

means (40) of adjusting the amount of energy delivered to said striking means according to the position of said powered units (4,5), and

acoustical detection means,

said apparatus further comprising means (8) of remotely controlling said powered units, said carriage, and said components, and of receiving, processing, and storing signals generated by said components.

2. The apparatus of Claim 1, comprising means (46,47,48) of detecting the distance between the carriage and a stator slot wedge.

3. The apparatus of Claims 1 and 2, wherein said striking means comprise a striker (36) attached to a free end of a holding rod (38) pivoted on said carriage and resilient means (40D) controlled by said means of adjusting the amount of energy delivered for applying a controlled actuating torque to said rod.

4. A troubleshooting method for monitoring the operability of an electric generator without removing its rotor, comprising the steps of:

mounting a pair of rings (1,2) on the rotor (2) ends of a generator to be monitored, each ring being provided with a powered unit (4,5) controlled to assume a plurality of predetermined positions on said rings,

stretching a carriage (11) driving cable (9) between said powered units,

inserting, between the rotor (2) and the stator (15) of said generator, a moving carriage (11) driven by means of said cable (9) to a plurality of predetermined positions along a stator slot of said generator,

picking up, during the movement of said carriage along said stator slot, a plurality of stator images using illuminating means (35) and first detection means (33,34) mounted on said carriage,

detecting a plurality of signals representing amounts of shorting currents between stator core laminations by means of second detection means (32) mounted on said carriage,

striking, with a predetermined and controlled amount of striking energy, each stator slot wedge, using striking means (36) mounted on said carriage,

detecting, using acoustical detection means mounted on said carriage, the acoustic signal generated at each striking,

detecting, using an accelerometer (37) coupled to said striking means (36), the deceleration imparted by each wedge to said striking means (36),

processing the detected signals to provide an indication of the degree of insulation of the stator core laminations and of the holding condition of each of said wedges.

5. The troubleshooting method of Claim 4, comprising the step of detecting the distance of said carriage from each stator slot wedge struck by said striking means.

6. The troubleshooting method of Claims 4, 5, comprising the step of controlling a striking torque applied to said striking means (36) according to the position of said powered units on said rings.

7. The method of Claims 4, 5, 6, wherein said processing includes double integration of said acoustic signal.

FIG.1

8

FIG.2

FIG.5

FIG.3

FIG.4